Europäisches Patentamt

European Patent Office

Office européen des brevets

(19)

(11) Veröffentlichungsnummer: **0 373 240**
**A1**

(12) **EUROPÄISCHE PATENTANMELDUNG**

(21) Anmeldenummer: **88120832.6**

(22) Anmeldetag: **13.12.88**

(51) Int. Cl.⁵: **H03K 17/04, H03K 17/08**

Geänderte Patentansprüche gemäss Regel 86 (2) EPÜ.

(43) Veröffentlichungstag der Anmeldung:
**20.06.90 Patentblatt 90/25**

(84) Benannte Vertragsstaaten:
**AT CH DE FR GB IT LI SE**

(71) Anmelder: **Siemens Aktiengesellschaft**
**Wittelsbacherplatz 2**
**D-8000 München 2(DE)**

(72) Erfinder: **Zwanziger, Peter, Dipl.-Ing.**
**Rennbahnstrasse 45**
**D-8500 Nürnberg(DE)**

(54) **Selbstregelnde Treiberschaltung mit Sättigungsgradregelung für den Basisstrom eines Leistungstransistors.**

(57) Die erfindungsgemäße Basisstromregelung dient insbesondere zur freien Einstellung des gewünschten Sättigungsgrades eines Leistungstransistors (T1) im eingeschalteten Zustand. Hierzu stellt eine parallel arbeitende Sättigungsgradregelung (SBR) durch Auswerten der mittels einer Ankoppeldiode (D2) abgegriffenen Spannung ($U_{CET1}$) am Ausgang des Leistungstransistors eine Hilfsstellgröße ($\Delta i_{BT1}$) im Kleinsignalbereich zur Verfügung. Diese wird bevorzugt dem Eingang eines Leistungsstellgliedes (LSG) in einer gesteuerten Treiberstufe (STS) zugeführt, welche die eigentliche Ansteuerenergie (SE) für den Basisstrom ($I_{BT1}$) des Leistungstransistors (T1) bereitstellt.

**FIG 1**

**EP 0 373 240 A1**

## Selbstregelnde Treiberschaltung mit Sättigungsgradregelung für den Basisstrom eines Leistungstransistors

Die Erfindung betrifft eine Vorrichtung zur Basisstromregelung bei einem Leistungstransistor mit den Merkmalen des Oberbegriffes von Anspruch 1.

Selbstregelnde Treiberschaltungen zur Bereitstellung des Basisstromes für einen Leistungstransistor müssen zum einen im stromleitenden Zustand des Transistors einen so hohen Basisstrom bereitstellen, daß die Stromleitung möglichst in jedem Betriebszustand des Transistors erhalten und die Durchlaßverluste möglichst klein bleiben. Es ist bekannt, dies insbesondere durch Bereitstellung eines so großen Basisstromes zu erreichen, daß sich der Transistor im Zustand der Übersättigung oder der Vollsättigung befindet.

Ein derartiger Betrieb eines Leistungstransistors ist aber nachteilig. Zum einen ist der Aufwand an insbesondere an Ansteuerenergie recht groß, da bei Erreichen des Sättigungsrandes des Transistors jede weitere Erhöhung des Basisstromes keine weitere Verbesserung des leitenden Zustandes und Erniedrigung der Transistorausgangsspannung, sondern lediglich eine Erhöhung der Verluste zur Folge hat. Desweiteren bewirkt ein derartiger Betrieb bei Leistungstransistoren, welche in Pulsumrichterschaltungen verwendet werden, daß gerade nicht stromführende Leistungstransistoren unnötig aufgesteuert werden. Treten in einem solchen Fall Gegenspannungen beispielsweise von einer vom Pulsumrichter betriebenen induktiven Last auf, so besteht die Möglichkeit, daß einer der Leistungstransistoren in den unerwünschten sogenannten Inversbetrieb übergeht. Dabei ist aber die Gefahr einer Transistorzerstörung aufgrund von plötzlichen Ausgangsspannungsänderungen hoher Steilheit bei Stromkommutierungsvorgängen besonders groß.

Der Betrieb eines Leistungstransistors im Zustand der Über- bzw. Vollsättigung führt aber auch bei der Transistorabschaltung zu erheblichen Problemen. Damit nach Beginn des Ausschaltvorganges der Laststrom durch den Transistor abklingen kann, müssen der Basiszone erst alle Ladungsträger entzogen und die Basis-Emitter-Strecke gesperrt werden. Die hierzu notwendige, Speicherzeit genannte Totzeit ist umso größer, je stärker sich der Transistor vor Beginn des Abschaltvorganges in der Sättigung befunden hat. Die Dauer dieser Totzeit hat einen erheblichen Einfluß auf die während des Abschaltvorganges auftretenden Verluste. Aus diesem Grund werden selbstregelnde Treiberschaltungen bevorzugt so ausgelegt, daß sich bei eingeschaltetem Leistungstransistor ein Arbeitspunkt möglichst am Sättigungsrand einstellt, d.h. möglichst im Gebiet der sogenannten Quasisättigung.

Hierzu ist z.B. aus der Veröffentlichung ELEKTRIE, Berlin 39 (1985) 5, Seite 180, Bild 7 eine selbstregelnde Treiberstufe bekannt, bei der zur Vermeidung der Über- bzw. Vollsättigung eine sogenannte Antisättigungsdiode verwendet wird. Hierdurch wird die Spannung am Ausgang des Transistors begrenzt auf die Summe aus der Spannung an der Basis-Emitterstrecke und der Durchlaßspannung der Antisättigungsdiode. Es ist somit möglich, überschüssige und zur Erreichung des Sättigungsrandes nicht benötigte Basisstromanteile des Transistorstellgliedes an die Kollektor-Emitter-Strecke des Transistors abzuführen. Eine derartige Schaltung hat den Nachteil, daß ständig hohe Ansteuerverluste auftreten. Zudem muß die Antisättigungsdiode so ausgelegt sein, daß sie u.U. hohe Ströme führen kann.

Eine weitere selbstregelnde Treiberstufe ist aus der in der DE-OS 32 15 009 enthaltenen FIG 3 bekannt. Dort ist zwischen einer Hilfsspannungsquelle und der Basis des anzusteuernden Leistungstransistors die Reihenschaltung aus einem schnellen Schalter und einem Stromregler angeordnet. Der Stromregler enthält einen Leistungstransistor, dessen Basis in bekannter Weise über eine Antisättigungsdiode mit dem Ausgang des anzusteuernden Leistungstransistors verbunden ist. Derartige, direkt vom Laststrom im anzusteuernden Leistungstransistors abhängige selbstregelnde Treiberstufen haben den Nachteil, daß die Basisstromregelschleife aufgrund von unvermeidlichen Leitungsinduktivitäten, der Basis-Emitterkapazität und Rückwirkungen des anzusteuernden Leistungstransistors recht instabil sind. Es tritt ständig einbe mehr oder weniger starke Oberschwingung im Basisstrom auf. Derartige Schwingungen können zwar durch einen Dämpfungswiderstand in der Zuführung zur Basis des Leistungstransistors verringert werden. Ein derartiger Widerstand hat aber wiederum eine Verringerung der Wirksamkeit der Antisättigungsdiode zur Folge.

Der Erfindung liegt die Aufgabe zugrunde, eine möglichst einfach aufgebaute und auf möglichst einfache Weise an bereits vorhandene Treiberschaltungen anpaßbare Vorrichtung anzugeben, welche die oben angeführten Nachteile der bekannten Schaltungen vermeidet.

Die Aufgabe wird gelöst mit den im Anspruch 1 angegebenen Merkmalen. Vorteilhafte Ausführungsformen der Erfindung sind in den Unteransprüchen angegeben.

Die Erfindung wird desweiteren anhand der nachfolgend kurz angeführten Figuren näher erläutert. Dabei zeigt:

FIG 1 das Blockschaltbild einer bevorzugten Ausführungsform der erfindungsgemäßen Vorrichtung, und

FIG 2 eine weitere vorteilhafte Ausführungsform der erfindungsgemäßen Vorrichtung im Detail.

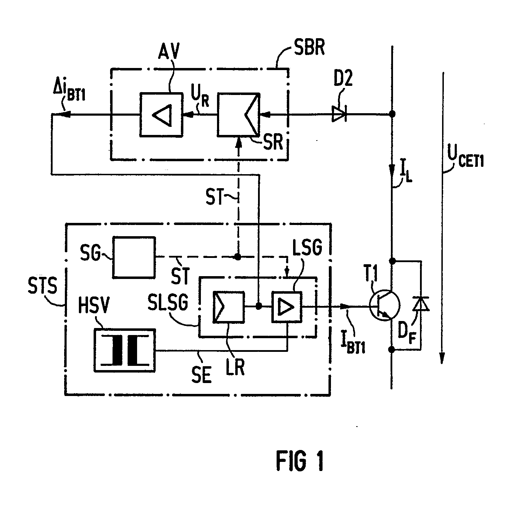

Bei der in der FIG 1 dargestellten vorteilhaften Ausführungsform der Erfindung wird der Leistungstransistor T1 von einer bevorzugt gesteuerten Treiberstufe STS mit Basisstrom $I_{BT1}$ geeigneten Vorzeichens versorgt. Die dazu notwendige Ansteuerenergie wird von einem bevorzugt aus einem Stellregler LR mit nachgeschaltetem Leistungsstellglied LSG bestehenden geregelten Leistungs stellglied SLSG zur Verfügung gestellt. Die Stellenergie SE wird dem Leistungsstellglied LSG bevorzugt von einer Hilfsspannungsversorgung HSV zugeführt. Mittels eines Steuergerätes SG und des davon abgegebenen Steuersignales ST kann das selbstregelnde Leistungsstellglied SLSG so umgeschaltet werden, daß der Basisstrom $I_{BT1}$ für eine Ein- bzw. Abschaltung des Leistungstransistors T1 vorzeichenrichtig bereitgestellt wird.

Gemäß der Erfindung wird die Spannung $U_{CET1}$ am Ausgang des Leistungstransistors T1 über eine insbesondere hochsperrende, schnelle Ankoppeldiode D2 der Sättigungsgradregelung SBR zugeführt. Diese enthält bevorzugt einen Sättigungsgradregler SR, welcher im eingeschalteten Zustand des Leistungstransistors T1 eine den gewünschten Sättigungsgrad aufrechterhaltende Hilfsstellgröße $\Delta i_{BT1}$ der gesteuerten Treiberstufe STS zuführt. Unter Zugrundelegung der in der FIG 1 dargestellten vorteilhaften Ausführungsform einer gesteuerten Treiberstufe STS ist es besonders vorteilhaft, wenn diese Hilfsstellgröße im geregelten Leistungsstellglied SLSG am Eingang des eigentlichen Leistungsgliedes LSG dem vom Stellregler LR zugeführten Stellsignal aufgeschaltet wird.

Eine derartige Anordnung hat den besonderen Vorteil, daß der Sättigungsgradregler SR im Kleinsignalbereich arbeitet und nicht wie ein Leistungstransistor zur Übertragung von Ansteuerenergie ausgelegt werden muß. Die erfindungsgemäße Trennung zwischen der die eigentliche Ansteuerenergie bereitstellenden Treiberstufe STS und der parallel dazu im Kleinsignalbereich auf wesentlich niedrigerem Energieniveau arbeitenden Sättigungsgradregelung SBR hat den besonderen Vorteil, daß die Sättigungsgradregelung nahezu rückwirkungsfrei vom Leistungsteil des Leistungstransistors T1 arbeitet. Hierdurch ist es möglich, daß die in der FIG 1 dargestellte und aus einer Ankoppeldiode D2, der Sättigungsgradregelung SBR und einer gesteuerten Treiberstufe STS bestehende Vorrichtung zur Basisstromregelung für den Leistungstransistor T1 in jedem Fall schwingungsfrei arbeitet. Es kann somit ein oberschwingungsfreier Basisstrom $I_{BT1}$ zur Ansteuerung des Leistungstransistors T1 zur Verfügung gestellt werden. Desweiteren ist es besonders vorteilhaft möglich, die Regelung insbesondere durch eine entsprechende Einstellung des Sättigungsgradreglers SR an die elektrischen Kenngrößen des jeweils verwendeten Leistungstransistors T1 anzupassen. Die Erfindung hat den besonderen Vorteil, daß aufgrund der freien Einstellbarkeit des im jeweils vorliegenden Anwendungsfall gewünschten Sättigungsgrades des Leistungstransistors T1 ein individueller Kompromiß zwischen den zum Teil gegenläufigen Forderungen nach möglichst kleinen Abschaltverlusten, möglichst kleinen Durchlaßverlusten und einer möglichst kurzen Speicherzeit einstellbar ist. Insbesondere wird dem Leistungstransistor nur soviel Basisstrom zugeführt, um den gewünschten Sättigungsgrad zu erreichen. Hierdurch wird insbesondere bei vorübergehendem zu Null oder negativ werden des Laststromes $I_L$ durch den Leistungstransistor eine unnötige Aufsteuerung vermieden. Es ergibt sich mit der erfindungsgemäßen Vorrichtung somit eine erhebliche Einsparung an Ansteuerleistung. Zudem wird das Auftreten des unerwünschten Inversbetriebes verhindert.

Die erfindungsgemäße Vorrichtung zeichnet sich desweiteren durch eine besonders einfache Nachrüstbarkeit aus. So kann insbesondere die Sättigungsgradregelung SBR aufgrund der im Kleinsignalbereich befindlichen Hilfsstellgröße am Ausgang auf einfache Weise an einen bereits mit einer bevorzugt gesteuerten Treiberstufe STS beschalteten Leistungstransistor T1 angekoppelt werden. Dies ist insbesondere dann von Vorteil, wenn der Leistungstransistor T1 gemeinsam mit der Treiberstufe STS bereits als eine kompakte Baueinheit vorhanden ist.

Gemäß der in der FIG 1 dargestellten Ausführungsform der erfindungsgemäßen Vorrichtung ist es vorteilhaft, wenn der Sättigungsgradregler SR über einen zusätzlichen Abkoppelverstärker AV mit bevorzugt hochohmigem Eingang und niederohmigem Ausgang auf die Treiberstufe STS einwirkt. Diese Maßnahme trägt zur weiteren Stabilisierung der erfindungsgemäßen Basisstromregelung bei.

Die Aktivierung bzw. Sperrung des Sättigungsgradreglers SR im ein- bzw. abgeschalteten Zustand des Leistungstransistors T1 kann gemäß der Darstellung von FIG 1 besonders vorteilhaft im Regler selbst vorgenommen werden. Hierzu wird dem Sättigungsgradregler das Steuersignal ST des Steuergerätes SG direkt zugeführt. Bei einer anderen vorteilhaften Ausführungsform wird hierzu eine separate Reglersperrvorrichtung RS verwendet, welche bevorzugt zwischen der Ankoppeldiode D2 und dem Sättigungsgradregler SR angeordnet und vom Steuersignal ST am Ausgang des Steuergerätes SG beaufschlagt wird. Eine derartige Reglersperrvorrichtung hat den Vorteil, daß mit ihrer Hilfe auch in anderen Betriebszuständen, insbesondere beim Auftreten von Fehlerfällen, eine Sperrung der Sättigungsgradregelung SBR möglich ist. So tritt z.B. bei über dem Nennwert liegenden Lastströmen $I_L$ und dem dadurch hervorgerufenen Anstieg der Spannung $U_{CET1}$ eine zunehmende Entsättigung des Leistungstransistors T1 auf. In einem solchen Fall würde die Sättigungsgradregelung den Basisstrom $I_{BT1}$ erhöhen, um den eingestellten Sättigungsgrad des Leistungstransistors T1 aufrechtzuerhalten. Eine derartige Aufsteuerung des Basisstromes muß aber im Überstromfall insbesondere durch Blockierung der Sättigungsgradregelung SBR bevorzugt über die zusätzliche Reglersperrvorrichtung RS vermieden werden.

In einer weiteren vorteilhaften Ausführungsform der Erfindung ist es zur Vermeidung des unerwünschten Inversbetriebes des Leistungstransistors T1 vorteilhaft, wenn der Sättigungsgradregler SR so eingestellt ist, daß die Hilfsstellgröße am Ausgang des Sättigungsgradreglers bei Fehlen oder Vorliegen eines negativen Laststromes $I_L$ einen Ruhestrom $I_{BT1}$ an der Basis des Leistungstransistors von einer solchen Größe hervorruft, daß das Auftreten eines Inversbetriebes verhindert und gleichzeitig bei einem u.U. plötzlichen, erneuten Übergang des Laststromes in die positive Richtung der stromleitende Zustand aufrechterhalten bleibt.

Dies hat bei dem in der FIG 1 beispielhaft dargestellten, aus dem Leistungstransistor T1 und der antiparallelen Freilaufdiode $D_F$ bestehenden Brückenzweig eines Pulsumrichters zur Folge, daß ein positiver Laststrom $I_L$ ausschließlich über den Leistungstransistor T1 und ein negativer Laststrom $I_L$ ausschließlich über die Freilaufdiode $D_F$ fließt. Es findet somit bei negativem Laststrom keine Stromaufteilung auf den Leistungstransistor T1 und die Freilaufdiode D1 statt. Desweiteren kann bei plötzlichem Wechsel des Laststromes von negativer auf positiver Stromführungsrichtung der Leistungstransistor sofort wieder die Stromführung übernehmen. Wäre in diesem Fall der Leistungstransistor im Inversbetrieb, so würden die durch den sogenannten Sperr-Erholungsvorgang der Freilaufdiode, d.h. deren kurzzeitigen Kurzschluß bis zum Erreichen der vollen Sperrfähigkeit, bedingten plötzlichen Spannungssprünge eine Gefahr für den Leistungstransistor darstellen.

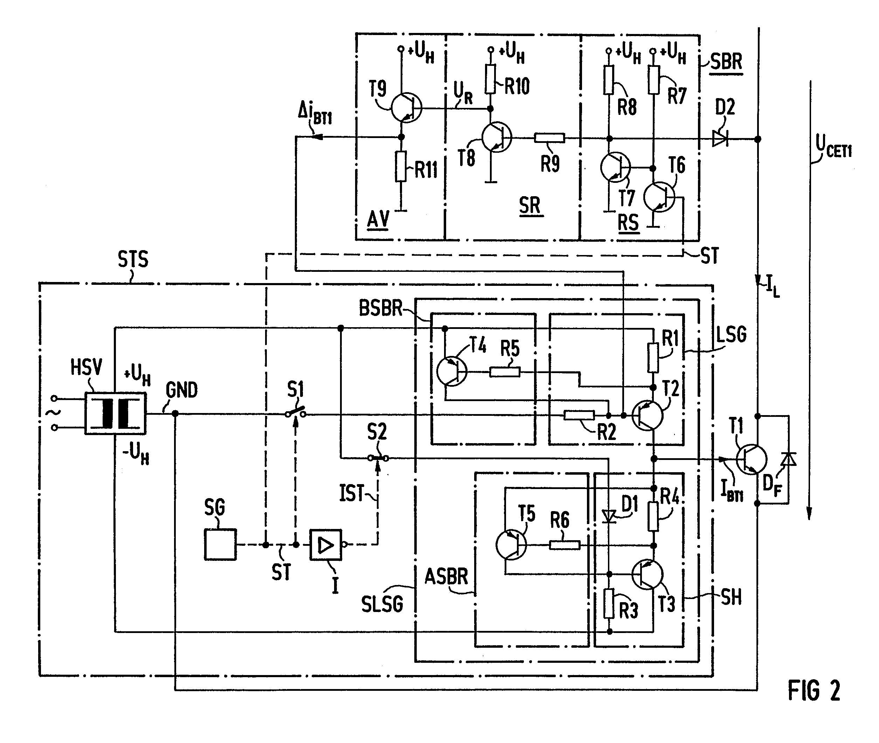

In der FIG 2 ist eine vorteilhafte Ausführungsform der erfindungsgemäßen Vorrichtung im Detail dargestellt. Das geregelte Leistungsstellglied SLSG in der gesteuerten Treiberstufe STS enthält dabei bevorzugt ein Leistungsstellglied LSG zur Bildung eines positiven Basisstromes $I_{BT1}$, einen damit verbundenen Basisstrombegrenzungsregler BSBR und eine Sperrhilfe SH zur Bereitstellung eines negativen Basisstromes $I_{BT1}$ mit einem damit verbundenen Ausräumstrombegrenzungsregler ASBR.

Das Leistungsstellglied LSG zur Bereitstellung eines positiven Basisstromes $I_{BT1}$ für die Einschaltung bzw. Aufrechterhaltung des leitenden Leitzustandes des Leistungstransistors T1 besteht bevorzugt aus einem Regeltransistor T2, welcher über einen Widerstand R1 mit dem positiven Potential $U_H$ einer Hilfsspannungsversorgung HSV verbunden ist. Die Basis dieses Regeltransistors T2 ist bevorzugt über einen weiteren Widerstand R2 und ein vom Steuersignal ST des Steuergerätes SG betätigtes erstes Schaltmittel S1 mit einem Massebezugspunkt GND verbunden. Das Schaltmittel S1 ist dann geschlossen, wenn zur Einschaltung bzw. Auf rechterhaltung des stromleitenden Schaltzustandes des Leistungstransistors T1 ein positiver Basisstrom $I_{BT1}$ zur Verfügung gestellt werden muß. Zu dessen Begrenzung dient ein auf das Leistungsstellglied LSD einwirkender zusätzlicher Basisstrombegrenzungsregler BSBR. Dieser besteht bevorzugt aus einer mit Hilfe des Transistors T4 und einem dazugehörigen Basiswiderstand R5 aufgebauten Konstantstromquelle. Zur Stromregelung wird die am Widerstand R1 abfallende Spannung abgegriffen. Der Strom dieser Konstantstromquelle wird zur Basisstrombegrenzung bevorzugt in den Steuereingang des Regeltransistors T2 im Leistungsstellgliedes LSG eingespeist.

Zur Bereitstellung eines negativen Basisstromes $I_{BT1}$ zur Abschaltung des Leistungstransistors T1 dient eine Sperrhilfevorrichtung SH. Diese besteht bevorzugt aus einem Transistor T3, welcher mit einer von der Hilfsspannungsversorgung HSV zur Verfügung gestellten negativen Hilfsspannung $-U_H$ und über einen Widerstand R4 mit der Basis des Leistungstransistors T1 verbunden ist. Zur Ansteuerung des Transistors T3 dient ein Basis-Kollektorwiderstand R3, welcher bevorzugt über eine Ansteuerdiode D1 und ein zweites Schaltmittel S2 mit dem positiven Potential $+U_H$ der Hilfsspannungsversorgung HSV verbunden ist. Dieses Schaltmittel ist dann geschlossen, wenn der Leistungstransistor T1 zum Zwecke der Abschaltung mit einem negativen Strom $I_{BT1}$ an der Basis beaufschlagt werden soll. Zu dessen Begrenzung dient ein zusätzlicher, auf die Sperrhilfevorrichtung SH einwirkender Ausräumstrombegrenzungsregler ASBR. Dieser ist wiederum besonders vorteilhaft in Form einer aus einem Transistor T5 mit Basiswiderstand R6 bestehenden Konstantstromquelle aufgebaut. Zur Regelung des Konstantstromes wird die am Emitterwiderstand R4 des Transistors T3 abfallende Spannung erfaßt. Der Konstantstrom wird schließlich am Steuereingang des Transistors T3 eingespeist.

Der Sättigungsgradregler SR in der Sättigungsgradregelung SBR ist gemäß der bevorzugten Ausführung von FIG 2 in Form eines im Kleinsignalbereich arbeitenden Transistors T8 in Emitterschal tung ausgeführt. Dem Transistor T8 wird die Spannung $U_{CET1}$ am Ausgang des Leistungstransistors T1 über einen Basiswiderstand R9 von der Ankoppeldiode D2 zugeführt. Der Kollektor des Transistors T8 ist über einen Kollektorwiderstand R10 mit dem positiven Potential $+U_H$ einer Hilfsspannungsversorgung verbunden. Durch geeignete Wahl der Widerstände R9 und R10 kann der Arbeitspunkt und die Verstärkung, d.h. der Stellbereich, abhängig von den elektrischen Parametern des jeweils verwendeten Leistungstransistors T1 so eingestellt werden, daß dieser im eingeschalteten Zustand mit dem jeweils gewünschten Sättigungsgrad betrieben wird. Zum anderen kann bei vorübergehendem Fehlen eines Laststromes $I_L$ im eingeschalteten Zustand ein gerade so großer Basisruhestrom hervorgerufen werden, daß das Auftreten eines Inversbetriebes verhindert wird.

Gemäß einer weiteren Ausführungsform der Erfindung wird das Ausgangsregelsignal $u_R$ am Kollektor des Transistors T8 über einen Abkoppelverstärker AV dem Steuereingang des Leistungsstellgliedes LSG als Hilfsstellgröße $\Delta i_{BT1}$ zugeführt. Dieser Abkoppelverstärker AV verfügt bevorzugt über einen hohen Eingangswiderstand und einen niedrigen Ausgangswiderstand. Dies wird bevorzugt durch einen als Impedanzwandler betriebenen Transistor T9 mit Emitterwiderstand R11 erreicht. Die als Ausgangssignal der Sättigungsgradregelung SGR dienende Hilfsstellgröße wird dabei am Emitter des Transistors T9 abgegriffen.

Die gemäß einer weiteren Ausführungsform der Erfindung vorteilhaft zwischen den Ankoppeldioden und dem Sättigungsgradregler angeordnete separate Reglersperrvorrichtung RS besteht gemäß der Schaltung von FIG 2 bevorzugt aus zwei hintereinander geschalteten Schalttransistoren T6 und T7, welche jeweils über einen Kollektorwiderstand R7 und R8 mit dem positiven Potential einer Hilfsspannungsversorgung verbunden sind. Dabei liegt am Steuereingang des ersten Schalttransistors T6 das Steuersignal ST vom Steuergerät SG an. Schließlich ist der Verbindungspunkt der An koppeldiode D2 mit dem Basiswiderstand R9 des Transistors T8 im Sättigungsgradregler SR mit dem Kollektor des zweiten Schalttransistors T7 verbunden.

**Ansprüche**

1. Vorrichtung zur Basisstromregelung bei einem Leistungstransistor (T1) mit

a) einer Ankoppeldiode (D2) zum Abgreifen der Spannung ($U_{CET1}$) am Ausgang des Leistungstransistors (T1),

b) einer bevorzugt gesteuerten Treiberstufe (STS), welche die Ansteuerenergie zur Ein- und Ausschaltung des Leistungstransistors (T1) an dessen Basiselektrode zur Verfügung stellt,

c) eine parallel arbeitende Sättigungsgradregelung (SBR), welche bei eingeschaltetem Leistungstransistor (T1) aus der Spannung ($U_{CET1}$) am Ausgang des Leistungstransistors (T1) eine den gewünschten Sättigungsgrad hervorrufende Hilfsstellgröße ($\Delta i_{BT1}$) für die Treiberstufe (STS) bildet.

2. Vorrichtung nach Anspruch 1, **gekennzeichnet** durch einen Sättigungsgradregler (SR) aus einem Transistor (T8) in Emitterschaltung, welcher über einen Basiswiderstand (R9) mit der Ankoppeldiode (D2) und über einen Kollektorwiderstand (R10) mit einer Versorgungsspannung ($+U_H$) verbunden ist, bei dem insbesondere die Einstellung des gewünschten Sättigungsgrades für den Leistungstransistor (T1) durch Auswahl des Basis- und Kollektorwiderstandes (R9,R10) erfolgt.

3. Vorrichtung nach Anspruch 1 oder 2, **gekennzeichnet** durch eine Reglersperrvorrichtung (RS) für die Sättigungsgradregelung (SBR), welche bei Auftreten eines Fehlerfalles, insbesondere bei zu großem Laststrom ($I_L$) im Leistungstransistor, und bei abgeschalteten Leistungstransistor die Sättigungsgradregelung außer Eingriff nimmt.

4. Vorrichtung nach Anspruch 3, **dadurch gekennzeichnet,** daß die Reglersperrvorrichtung (RS) zwischen der Ankoppeldiode (D2) und der Sättigungsgradregelung (SBR) angeordnet ist.

5. Vorrichtung nach einem der vorangegangenen Ansprüche, **gekennzeichnet** durch einen zwischen dem Ausgang der Sättigungsgradregelung (SBR) und der Treiberstufe (STS) angeordneten Abkoppelverstärker (AV) mit hohem Eingangswiderstand und niedrigem Ausgangswiderstand.

6. Vorrichtung nach einem der vorangegangenen Ansprüche, **dadurch gekennzeichnet,** daß die Hilfsstellgröße ($\Delta i_{BT1}$) der Sättigungsgradregelung (SBR) bei Fehlen bzw. Vorliegen eines negativen Laststromes ($I_L$) im eingeschalteten Zustand des Leistungstransistors (T1) einen Basis-Ruhestrom ($I_{BT1}$) von einer solchen Größe hervorruft, daß beim Leistungstransistor (T1) der Inversbetrieb verhindert und der stromleitende Zustand bei erneutem Übergang des Laststromes in positive Richtung aufrechterhalten wird.

Geänderte Patentansprüche gemäss Regel 86(2) EPÜ.

1. Vorrichtung zur Regelung des Basisstromes eines Leistungstransistor (T1) mit

a) einer einstellbaren Treiberstufe (STS), welche die Ansteuerenergie für die Einschaltung des Leistungstransistors (T1) an dessen Basiselektrode bereitstellt,

b) einer Ankoppeldiode (D2) zum Abgreifen der Spannung ($U_{CET1}$) am Ausgang des Leistungstransistors (T1), und

c) einer zur einstellbaren Treiberstufe (STS) parallel arbeitenden Sättigungsgradregelung (SBR), welcher über die Ankoppeldiode (D2) die Spannung am Ausgang des Leistungstransistors als Regelabweichung zugeführt wird un welche hieraus eine Hilfsstellgröße ($\Delta i_{BT1}$) zur Einstellung der Treiberstufe derart bildet, so daß dem Leistungstransistor durch die Treiberstufe gerade soviel Ansteuerenergie zugeführt wird, um diesen mit einem gewünschten Sättigungsgrad, insbesondere am Sättigungsrand, zu betreiben.

2. Vorrichtung nach Anspruch 1, **gekennzeichnet** durch eine Sättigungsgradregelung (SBR) mit einem Sättigungsgradregler (SR) aus einem Transistor (T8) in Emitterschaltung, welcher über einen Basiswiderstand (R9) mit der Ankoppeldiode (D2) und über einen Kollektorwiderstand (R10) mit einer Versorgungsspannung ($+U_H$) verbunden ist, bei dem zumindest die Einstellung des gewünschten Sättigungsgrades für den Leistungstransistor (T1) durch Auswahl des Basis- und Kollektorwiderstandes (R9, R10) erfolgt, und die Hilfsstellgröße am Emitter des Transistors (T8) ausgegeben wird.

3. Vorrichtung nach Anspruch 1 oder 2, **gekennzeichnet** durch eine Reglersperrvorrichtung (RS) für die Sättigungsgradregelung (SBR), welche bei Auftreten eines Fehlerfalles, insbesondere bei zu großem Laststrom ($I_L$) im Leistungstransistor, und bei abgeschalteten Leistungstransistor die Sättigungsgradregelung außer Eingriff nimmt.

4. Vorrichtung nach Anspruch 3, **dadurch gekennzeichnet,** daß die Reglersperrvorrichtung (RS) zwischen der Ankoppeldiode (D2) und der Sättigungsgradregelung (SBR) angeordnet ist.

5. Vorrichtung nach einem der vorangegangenen Ansprüche, **gekennzeichnet** durch einen zwischen dem Ausgang der Sättigungsgradregelung (SBR) und der Treiberstufe (STS) angeordneten Abkoppelverstärker (AV) mit hohem Eingangswiderstand und niedrigem Ausgangswiderstand.

6. Vorrichtung nach einem der vorangegangenen Ansprüche, **dadurch gekennzeichnet,** daß die Hilfsstellgröße ($\Delta i_{BT1}$) der Sättigungsgradregelung (SBR) bei Fehlen bzw. Vorliegen eines negativen Laststromes ($I_L$) im eingeschalteten Zustand des Leistungstransistors (T1) einen Basis-Ruhestrom ($I_{BT1}$) von einer solchen Größe hervorruft, daß beim Leistungstransistor (T1) der Inversbetrieb verhindert und der stromleitende Zustand bei erneutem Übergang des Laststromes in positive Richtung aufrechterhalten wird.

l8 P 3544 E

FIG 1

FIG 2

EP 0 373 240 A1

I8 P 3544 E

**Europäisches Patentamt**

# EUROPÄISCHER RECHERCHENBERICHT

Nummer der Anmeldung

EP 88 12 0832

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 755 741 (NELSON)<br>* Spalte 6, Zeile 25 - Spalte 8, Zeile 26; Spalte 12, Zeile 41 - Spalte 13, Zeile 3; Figuren 3,5 * | 1 | H 03 K 17/04<br>H 03 K 17/08 |
| A | ----- | 2 | |

|  |  |
|---|---|
| | **RECHERCHIERTE SACHGEBIETE (Int. Cl.5)**<br><br>H 03 K<br>H 01 H |

**Der vorliegende Recherchenbericht wurde für alle Patentansprüche erstellt**

| Recherchenort | Abschlußdatum der Recherche | Prüfer |
|---|---|---|
| DEN HAAG | 18-07-1989 | CANTARELLI R.J.H. |